(19) Europäisches Patentamt
European Patent Office
Office européen des brevets

(11) **EP 3 284 167 B1**

(12) **EUROPÄISCHE PATENTSCHRIFT**

(45) Veröffentlichungstag und Bekanntmachung des Hinweises auf die Patenterteilung:
**01.11.2023  Patentblatt 2023/44**

(21) Anmeldenummer: **16720312.4**

(22) Anmeldetag: **11.04.2016**

(51) Internationale Patentklassifikation (IPC):
**H02P 9/02** *(2006.01)*    **H02P 29/024** *(2016.01)*

(52) Gemeinsame Patentklassifikation (CPC):
**H02P 9/02; H02P 29/0241**

(86) Internationale Anmeldenummer:
**PCT/AT2016/000036**

(87) Internationale Veröffentlichungsnummer:
**WO 2016/164944 (20.10.2016 Gazette 2016/42)**

(54) **VERFAHREN ZUR ERKENNUNG EINES BEVORSTEHENDEN POLSCHLUPFES**

METHOD FOR DETECTING AN IMMINENT POLE SLIP

PROCÉDÉ POUR LA RECONNAISSANCE D'UN GLISSEMENT DE PÔLE IMMINENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.04.2015   AT 2332015**

(43) Veröffentlichungstag der Anmeldung:
**21.02.2018   Patentblatt 2018/08**

(73) Patentinhaber: **Innio Jenbacher GmbH & Co OG 6200 Jenbach (AT)**

(72) Erfinder:
• FAHRINGER, Albert
  **6345 Kössen (AT)**
• KRUCKENHAUSER, Erich
  **6232 Münster (AT)**

(74) Vertreter: **Torggler & Hofmann Patentanwälte - Innsbruck**
**Torggler & Hofmann Patentanwälte GmbH & Co KG**
**Postfach 85**
**6020 Innsbruck (AT)**

(56) Entgegenhaltungen:
**WO-A1-2011/088483     US-A1- 2013 168 960**

• **SANAYE-PASAND M ED - INSTITUTE OF ELECTRICAL AND ELECTRONICS ENGINEERS: "Study, comparison and simulation of power system swing detection and prediction methods", 2003 IEEE POWER ENGINEERING SOCIETY GENERAL MEETING. CONFERENCE PROCEEDINGS. TORONTO, ONTARIO, CANADA, JULY, 13 - 17, 2003; [IEEE POWER ENGINEERING SOCIETY], NEW YORK, NY : IEEE, US, Bd. 1, 13. Juli 2003 (2003-07-13), Seiten 27-32, XP010687218, DOI: 10.1109/PES.2003.1267122 ISBN: 978-0-7803-7989-3**
• **Andreas Binder: "Elektrische Maschinen und Antriebe: Grundlagen, Betriebsverhalten", 9. Dezember 2012 (2012-12-09), Springer-Verlag, XP002759661, ISBN: 978-3-540-71849-9 Seiten 584-585, das ganze Dokument**
• **OHURA Y ET AL: "A PREDICTIVE OUT-OF-STEP PROTECTION SYSTEM BASED ON OBSERVATION OF THE PHASE DIFFERENCE BETWEEN SUBSTATIONS", IEEE TRANSACTIONS ON POWER DELIVERY, IEEE SERVICE CENTER, NEW YORK, NY, US, vol. 5, no. 4, 1 October 1990 (1990-10-01) , pages 1695-1704, XP000171126, ISSN: 0885-8977, DOI: 10.1109/61.103664**

**Beschreibung**

Die Erfindung betrifft ein Verfahren zur Erkennung eines bevorstehenden Polschlupfes eines mit einem Energieversorgungsnetz elektrisch verbundenen Synchrongenerators. Ferner betrifft die Erfindung eine Vorrichtung zur Erkennung eines bevorstehenden Polschlupfes.

Der Polradwinkel, auch Lastwinkel genannt, ist jener Winkel, unter dem der Rotor einer Synchronmaschine, auch Polrad genannt, dem Synchrondrehfeld vorauseilt (Generatorbetrieb) bzw. nacheilt (Motorbetrieb). Der Zusammenhang zwischen Lastwinkel und Polradwinkel besteht über die Polpaarzahl der Synchronmaschine, wobei sich der Lastwinkel aus der Multiplikation des Polradwinkels mit der Polpaarzahl der Synchronmaschine (z.B. eines Synchrongenerators) ergibt.

Der Lastwinkel ist ein Maß für die Stabilität des Synchrongeneratorbetriebs. Bei einem mit einem Energieversorgungsnetz verbundenen Synchrongenerator drückt der Lastwinkel die Abweichung der Magnetpole am Rotor des Synchrongenerators von den Magnetpolen am Stator des Synchrongenerators aus. Die Magnetpole am Rotor werden dabei üblicherweise durch eine Gleichstrom-gespeiste Erregerwicklung am Rotor erzeugt. Die Magnetpole am Stator des Synchrongenerators werden durch die an die Drehstromwicklung am Stator angelegte elektrische Spannung des Energieversorgungsnetzes, welches typischerweise dreiphasig ausgeführt ist, erzeugt.

Der Lastwinkel beschreibt im Zeigermodell den Winkel zwischen der Ständerspannung und der Rotorspannung bzw. Polradspannung, wobei die Polradspannung im Synchrongeneratorbetrieb der Ständerspannung vorauseilt. Bei steigender Belastung durch das Energieversorgungsnetz, d. h. bei erhöhter Energiebereitstellung durch den Synchrongenerator, erhöht sich dieser Lastwinkel. Wird der Lastwinkel zu groß, führt dies zu einer Instabilität des Synchrongenerators. Üblich sind Lastwinkel im Generatorbetrieb um 20° bis 30° bei Nennleistung. Wird der Lastwinkel zu groß, führt dies zu einer Instabilität des Generators. Dieses Kippen in den instabilen Betriebszustand wird bekanntermaßen als Polschlupf bezeichnet. Polschlupf kann zu Schäden am Generator und / oder damit verbundenen Leistungsteilen führen. Es ist daher für den Betrieb von Synchrongeneratoren wesentlich, den Lastwinkel zu kennen.

Aus dem Stand der Technik sind zahlreiche Verfahren zur Ermittlung eines Lastwinkels bekannt.

Aus der DE 10 2010 001248 A1 ist beispielsweise bekannt, über die erfasste Zeit zwischen dem Auftreten eines Drehzahlsignals vom Rotor des Synchrongenerators und dem Auftreten eines Spannungsnulldurchganges eines Spannungssignals des Energieversorgungsnetzes auf den Lastwinkel zu schließen.

Die AT 514007 A1 der Anmelderin offenbart ein Verfahren zur Ermittlung eines Lastwinkels eines mit einem Energieversorgungsnetz elektrisch verbundenen Synchrongenerators, wobei aus einer Zeitdauer zwischen einer Meldung eines Drehzahlsignals und einer Meldung des Frequenzsignals auf den Lastwinkel geschlossen wird.

Die AT 514024 A1 zeigt ein Verfahren zur Erkennung von Polschlupf, wobei die mechanische Rotationsfrequenz der Motorwelle und eine elektrische Rotationsfrequenz des Energieversorgungsnetzes erfasst oder ermittelt werden, wobei bei einer Abweichung der mechanischen Rotationsfrequenz von der elektrischen Rotationsfrequenz größer eines vorgebbaren Schwellwerts ein Signal ausgegeben wird, wobei das Signal als detektierter Polschlupf angesehen wird. Dieses Verfahren beruht darauf, dass bei Auftreten von Polschlupf die Antriebsmaschine - ausgehend von ihrer im Wesentlichen konstanten Drehzahl während des stabilen stationären Betriebsmodus - hochdreht.

Mit den aus dem Stand der Technik bekannten Verfahren ist es allerdings nicht möglich, den Lastwinkel bei Auftreten einer Netzstörung im Energieversorgungsnetz zu bestimmen, da die Verfahren auf Größen zugreifen, die bei Auftreten eines Netzfehlers nicht zur Bestimmung des Lastwinkels herangezogen werden können.

Auch sind die Verfahren nicht geeignet, einen drohenden Polschlupf zu erkennen, sondern detektieren erst das Auftreten eines solchen.

Die US 2013/168960 A1 beschreibt eine Methode, um bei Verwendung von Synchrongeneratoren das Auftreten von Polschlupf zu detektieren und bei Auftreten von Polschlupf das Trennen eines solchen Generators vom Netz vorzunehmen. Es wird dabei näher darauf eingegangen, dass ein Lastwinkel mit Hilfe der Rotorfrequenz und der Starterfrequenz berechnet wird.

Eine weitere aus dem Stand der Technik bekannte Ausführungsform geht aus der WO 2011/088483 A1 hervor. Eine weitere Ausführungsform ist in XP000171126 Y. Ohura et al., "A predictive out-of-step protection system based on observation of the phase difference between substations," in IEEE Transactions on Power Delivery, vol. 5, no. 4, pp. 1695-1704, Oct. 1990, doi: 10.1109/61.103664. offenbart.

Aufgabe der Erfindung ist es daher, ein Verfahren zur Erkennung eines bevorstehenden Polschlupfes anzugeben. Insbesondere soll die Erkennung eines bevorstehenden Polschlupfes bei Auftreten eines Netzfehlers im Energieversorgungsnetz ermöglicht werden. Das Auftreten von Polschlupf soll verhindert werden.

Diese Aufgabe wird erfindungsgemäß durch die Merkmale des Patentanspruchs 1 bzw. durch die Merkmale des Patentanspruchs 7 gelöst. Vorteilhafte Ausgestaltungen der Erfindung sind in den abhängigen Ansprüchen angegeben.

Gemäß der Erfindung ist also vorgesehen, dass das Verfahren zur Ermittlung eines Lastwinkels eines mit einem Energieversorgungsnetz elektrisch verbundenen Synchrongenerators bei Auftreten einer Netzstörung im Energieversorgungsnetz folgende Schritte umfasst:

- Bestimmung eines ersten Wertes eines Generatorlastwinkels im netzstörungsfreien Betrieb,
- Ermittlung einer Generatorfrequenz in Abhängigkeit von der Zeit bei Auftreten einer Netzstörung und
- Vorausberechnung eines zweiten Wertes eines aus der Netzstörung resultierenden Lastwinkels durch Addieren des ersten Wertes des Lastwinkels mit einer während der Netzstörung auftretenden Lastwinkeldifferenz, welche Lastwinkeldifferenz durch eine Abweichung einer Generatorfrequenz relativ zu einer Netzfrequenz verursacht ist und aus dem Integral aus der Generatorfrequenz aus einer Drehzahlmessung des Synchrongenerators gebildet wird.

Es wird also erfindungsgemäß zunächst über an sich bekannte Verfahren der Lastwinkel im netzstörungsfreien Betrieb bestimmt. Weiters wird, in Abhängigkeit von der Zeit, eine Generatorfrequenz bei Auftreten einer Netzstörung ermittelt. Während in einem netzstörungsfreien Betrieb die Generatorfrequenz im Wesentlichen der Netzfrequenz entspricht, treten bei einer Netzstörung Abweichungen der Generatorfrequenz von der Netzfrequenz auf. Der aus der Netzstörung resultierende Lastwinkel wird nun dadurch berechnet, indem der erste Wert des Lastwinkels (jener Lastwinkel, der im netzstörungsfreien Betrieb vor Auftreten der Netzstörung bestand) mit einer während der Netzstörung auftretenden Lastwinkeldifferenz g addiert wird, wobei diese Lastwinkeldifferenz das Ergebnis der Abweichung einer Generatorfrequenz relativ zu einer Netzfrequenz darstellt. Diese Berechnung erfolgt vorzugsweise fortlaufend. Im Folgenden sei die Grundidee der Erfindung noch einmal erläutert:

Netzfehler werden beispielsweise durch einen netzseitigen Kurzschluss verursacht. In einem solchen Fall fällt die Generatorspannung auf null und der Generator kann gegenüber dem Energieversorgungsnetz keine Leistung mehr erbringen. Dies führt zum Beschleunigen des Synchrongenerators in Richtung einer Asynchronizität, die zu einer Zerstörung des Synchrongenerators führen kann. Ein Netzfehler vergrößert also den Lastwinkel bis im schlimmsten Fall ein Polschlupf erreicht ist. Bei einem Polschlupf treten sehr große Ströme in den Generatorwicklungen auf, die den Generator zerstören können.

Die Netzfrequenz des Energieversorgungsnetzes bleibt jedoch auch bei Auftreten eines Netzfehlers im Wesentlichen konstant. Gemäß der Erfindung wird nun jener Winkelversatz, der sich aus der sich ändernden Generatorfrequenz gegenüber der Netzfrequenz auftritt, bestimmt und diese Lastwinkeldifferenz zum ersten Wert des Lastwinkels aus dem netzstörungsfreien Betrieb vor Auftreten des Netzfehlers hinzugezählt. Dadurch wird der aus der Netzstörung resultierende Lastwinkel bestimmt.

Der Lastwinkel im netzstörungsfreien Betrieb - auch netzgültiger Lastwinkel genannt - wird beispielsweise kontinuierlich durch Speichern des aktuellen Wertes für den Lastwinkel erfasst. Dies kann etwa durch einen Speicher erfolgen, in welchem die Werte für den Lastwinkel der letzten vergangenen 500 ms (Millisekunden) gemittelt werden.

Sobald eine Netzstörung detektiert wird, wird die Messung des netzgültigen Lastwinkels unterbrochen und der letzte gültige Wert gespeichert und nicht mehr überschrieben.

Dieser Wert dient dann als jener Betrag des Lastwinkels, zu welchem die oben beschriebene Lastwinkeldifferenz hinzugezählt wird, um den aus der Netzstörung resultierenden Lastwinkel zu berechnen.

Die Lastwinkeldifferenz wird so bestimmt, dass ein Integral aus der Motorfrequenz (= Generatorfrequenz) aus einer Drehzahlmessung des Generators gebildet wird. Das Ergebnis dieses Integrals bildet die Lastwinkeldifferenz, die zu dem letztgültigen Wert des netzgültigen Lastwinkels hinzugezählt wird, um den aus der Netzstörung resultierenden Lastwinkel zu berechnen.

Bevorzugt ist vorgesehen, dass nach Detektion eines für einen Netzfehler charakteristischen Signals eine Lastwinkeldifferenz zwischen Polradspannung und Generatorspannung bestimmt wird, welche (Lastwinkeldifferenz) durch eine Abweichung einer Generatorfrequenz relativ zu einer Netzfrequenz verursacht ist. Die Polradspannung und die Generatorspannung werden als vektorielle Größen betrachtet, sodass die Lastwinkeldifferenz sich zwischen den Vektoren ergibt.

Im vorliegenden Fall eines Netzparallelbetriebs ist die Netzspannung gleich der Generatorspannung.

Bevorzugt ist vorgesehen, dass der Lastwinkel im netzstörungsfreien Betrieb durch Messen einer Generatorspannung und eines Generatorstroms erfolgt. Der Lastwinkel im netzstörungsfreien Betrieb wird auch als statischer Lastwinkel bezeichnet.

Die Berechnung des Lastwinkels $\vartheta$ im netzstörungsfreien Betrieb aus einer Generatorspannung und einem Generatorstrom erfolgt dann über die Formel

$$\mathrm{Tan}\,\vartheta = (I_o * X_q * \cos \varphi) / (U_o + I_o * X_q * \sin \varphi)$$

mit $U_O$ = Generator-Betriebsspannung an Ph-N, $I_O$ = Generator-Betriebsstrom, $Xq = Xq_{Gen}$ * $U_{Nominal}$ / $I_{Nominal}$ mit $Xq_{Gen}$ = Reaktanz aus Generator-Datenblatt, $U_{Nominal}$ = Generator-Nennspannung Ph-N, $I_{Nominal}$ = Generator Nenn(phasen) strom.

Zur Bestimmung der Generatorfrequenz bestehen insbesondere die Möglichkeiten der Messung über einen Motor-Pickup, d. h. eine Messung der Motordrehzahl, oder über den Generatorstrom, d. h. über eine elektrische Größe des Generators. Die Bestimmung der Generatorfrequenz über die Beobachtung der Null-Durchgänge des Generatorstroms ist besonders vorteilhaft gegenüber einer Bestimmung der Generatorfrequenz aus einer Beobachtung von Null-Durchgängen der Generatorspannung, da im Falle eines netzseitigen Kurzschlusses diese Spannung Null sein kann.

Es kann vorgesehen sein, dass bei Überschreiten eines ersten vorgebbaren Wertes für den aus der Netzstörung resultierenden Lastwinkel wenigstens eine Maßnahme zur Reduzierung des Lastwinkels gesetzt wird. Dieser Aspekt kommt bevorzugt dann zum Tragen, wenn der Synchrongenerator Teil einer Stromerzeugungsanlage ist. Ist der Synchrongenerator beispielsweise mit einer Brennkraftmaschine zu einem Genset angeordnet, so kann der Lastwinkel durch Eingriffe auf die Brennkraftmaschine (etwa Drosselung der Kraftstoffzufuhr) oder über eine mechanische Bremse limitiert werden.

Bevorzugt ist vorgesehen, dass aus dem berechneten Wert eines aus der Netzstörung resultierenden Lastwinkels eine Entscheidung darüber abgeleitet wird, ob der Synchrongenerator mit dem Energieversorgungsnetz verbunden bleibt.

So kann vorgesehen sein, dass bei Überschreiten eines zweiten vorgebbaren Wertes für den aus der Netzstörung resultierenden Lastwinkels der Synchrongenerator von dem Energieversorgungsnetz getrennt wird. Dieser Aspekt zeigt einen wesentlichen Vorteil des vorgeschlagenen Verfahrens, da die Auswirkungen des Netzfehlers auf den Lastwinkel erfasst werden können und somit eine Entscheidungsgrundlage geschaffen ist, ob der Synchrongenerator zur Vermeidung von Schäden von den Energieversorgungsnetz getrennt werden muss. Dafür kann beispielsweise ein maximal zulässiger Wert für den Lastwinkel hinterlegt sein, bei dessen Überschreitung der Synchrongenerator von dem Energieversorgungsnetz getrennt wird.

Schutz wird auch begehrt für eine Vorrichtung zur Ermittlung eines Lastwinkels nach Anspruch 8.

Bevorzugt ist vorgesehen, dass die Vorrichtung ferner eine mit dem Synchrongenerator mechanisch gekoppelte mechanische Leistungsquelle umfasst. Es kann vorgesehen sein, dass die mechanische Leistungsquelle eine Brennkraftmaschine, besonders bevorzugt ein stationärer Motor (z.B. Gasmotor, Dieselmotor, Benzinmotor, Dual-Fuel-Motor) ist. Auch kann vorgesehen sein, dass die mechanische Leistungsquelle eine Windkraftanlage, eine Wasserkraftanlage oder eine Gasturbine ist.

Die Erfindung wird durch Figuren näher erläutert. Dabei zeigt:

Fig. 1   eine Darstellung des Lastwinkels im Zeigermodell,
Fig. 2   eine schematische Darstellung eines Synchrongenerators,
Fig. 3   eine schematische Darstellung eines Synchrongenerators verbunden mit einer mechanischen Leistungsquelle,
Fig. 4   ein Diagramm von Drehzahl- und Lastwinkeldifferenz nach Auftreten eines Netzfehlers in Abhängigkeit von der Zeit und
Fig. 5   ein Ablaufdiagramm eines Ausführungsbeispiels.

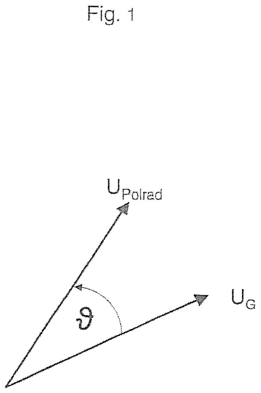

Fig. 1 zeigt eine Darstellung des Lastwinkels $\vartheta$ im Zeigermodell eines Synchrongenerators. Der Lastwinkel $\vartheta$ wird zwischen der Polradspannung $U_{Polrad}$ und der Generatorspannung $U_G$ aufgespannt. Der Pfeil beim Lastwinkel $\vartheta$ gibt die Drehrichtung an. Im vorliegenden Fall eines Netzparallelbetriebs ist die Generatorspannung gleich der Netzspannung. Im Generatorbetrieb des Synchrongenerators läuft also die Polradspannung $U_{Polrad}$ der Generatorspannung $U_G$ (also auch der Netzspannung) voraus. Im normalen Generatorbetrieb beträgt der Lastwinkel in der Regel zwischen 20° und 30°. Bei Überschreiten eines Lastwinkels von 180° elektrisch tritt Polschlupf auf und der Synchrongenerator verlässt die Synchronisation mit dem Energieversorgungsnetz.

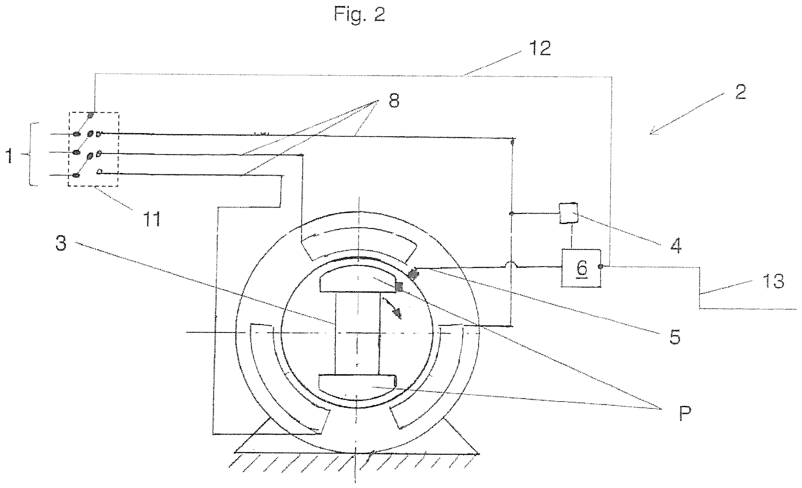

Fig. 2 zeigt eine schematische Darstellung eines Synchrongenerators 2, dessen Rotor (Polrad) zwei Pole P aufweist.

Die Phasen 8 des Synchrongenerators 2 sind mit einem Energieversorgungsnetz 1 durch die Auswerteeinheit 6 über eine Signalleitung 12 mittels einer Schaltvorrichtung 11 trennbar verbunden. Über eine weitere Signalleitung 13 kann die Auswerteeinheit 6 Eingriffe an einer nicht dargestellten mechanischen Leistungsquelle 7 vornehmen. Bevorzugt ist die Auswerteeinheit 6 in einer Steuereinheit des Synchrongenerators 2 und / oder in einer Steuereinheit der mechanischen Leistungsquelle 7 ausgebildet.

Weiters gezeigt ist eine Drehzahlmesseinrichtung 5 zur Bestimmung der Drehzahl des Rotors 3. Die Messeinrichtung 4 dient zur Bestimmung einer Frequenz einer Generatorspannung $U_G$ und/oder eines Generatorstroms $I_G$ des Synchrongenerators 2. Weiters gezeigt ist eine Auswerteeinheit 6, an welche die Signale der Messeinrichtung 4 und der Drehzahlmesseinrichtung 5 meldbar sind.

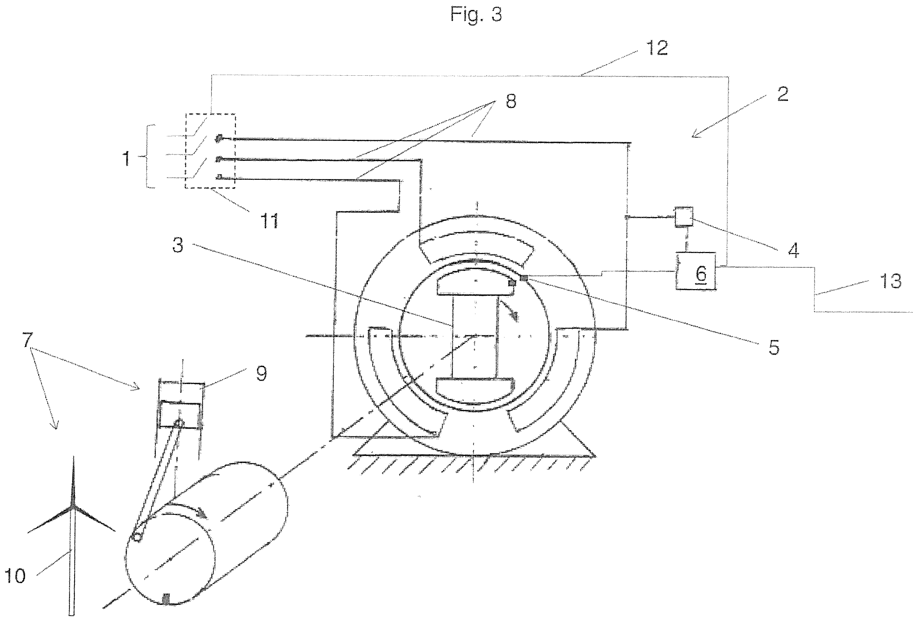

Fig. 3 zeigt eine weitere Darstellung eines Synchrongenerators 2, wobei dieser in dieser Darstellung mit einer mechanischen Leistungsquelle 7 über den Rotor 3 verbunden ist. Beispielhaft ist die mechanische Leistungsquelle 7 als eine Brennkraftmaschine 9 oder eine Windkraftanlage 10 dargestellt.

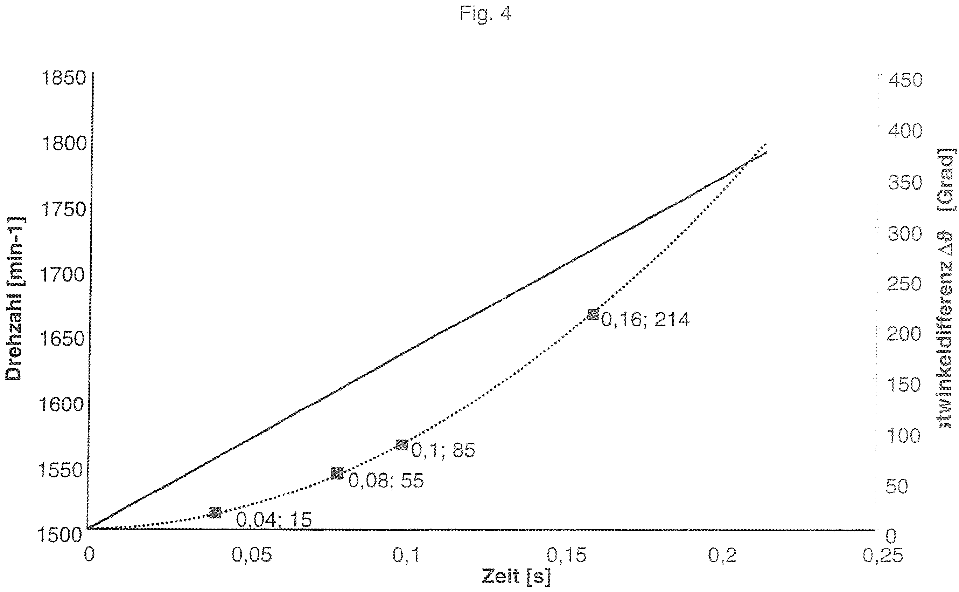

Fig. 4 zeigt einen Zusammenhang des Drehzahlverlaufes eines Synchrongenerators 2 mit der Lastwinkeldifferenz $\Delta\vartheta$ bei Auftreten eines Netzfehlers im Energieversorgungsnetz 1. Die durchgezogene Linie stellt die Drehzahlentwicklung des Synchrongenerators 2 in Abhängigkeit der auf der X-Achse aufgetragenen Zeit dar. Die entsprechende Ordinate der Drehzahl in Umdrehungen pro Minute ist auf der linken Ordinatenachse des Diagrammes angegeben. Man erkennt, dass die Drehzahl des Synchrongenerators 2, beginnend von der Nenndrehzahl durch Wegfall der elektrischen Last im Energieversorgungsnetz 1 ansteigt.

Als punktierte Kurve dargestellt ist eine Lastwinkeldifferenz $\Delta\vartheta$ in Grad, welche sich bedingt durch die Beschleunigung des Synchrongenerators 2 nach einem Netzfehler am Energieversorgungsnetz 1 aufbaut. Unter Lastwinkeldifferenz $\Delta\vartheta$ ist jener Winkelbetrag zu verstehen, welcher aus der Abweichung der Generatorfrequenz $f_G$ relativ zur Netzfrequenz $f_{grid}$ resultiert. Da die Netzfrequenz $f_{grid}$ als konstant und gegeben anzusehen ist, wird die Lastwinkeldifferenz im Wesentlichen von der Veränderung der Generatorfrequenz $f_G$ verursacht. Die zur Kurve der Lastwinkeldifferenz $\Delta\vartheta$ gehörige Ordinate ist die rechte Ordinatenachse des Diagramms.

Die Berechnung der Lastwinkeldifferenz $\Delta\vartheta$ sei anhand eines Zahlenbeispiels illustriert: die Generatordrehzahl vor Netzfehler (Startdrehzahl) sei 1500 U/min. Als Frequenz ausgedrückt, entspricht dies einer Generatorfrequenz $f_G$ von 25 Hz. Nach einer Zeit von 0,005 s (Sekunden) nach Netzfehler sei die Drehzahl auf 1507 U/min angestiegen. Die Drehzahldifferenz geteilt durch 60 mal der Zeitdifferenz (0,005 s - 0 s) mal 360 mal Anzahl der Polpaare (die Anzahl der Polpaare sei hier 2) ergibt die aktuelle Lastwinkeldifferenz zum Zeitpunkt 0,005 s nach Netzfehler, in diesem Beispiel 0,4 Grad. Die Berechnung der Lastwinkeldifferenz erfolgt nun weiter durch Aufaddieren bzw. Integrieren, beispielsweise bis zum Überschreiten eines ersten vorgebbaren Wertes für den aus der Netzstörung resultierenden zweiten Lastwinkels, $\vartheta_{fail}$ ,mit $\vartheta_{fail} = \vartheta_{op} + \Delta\vartheta$.

Die Steigerung eines Lastwinkels über einen vorgebbaren Wert kann als drohender Polschlupf interpretiert werden.

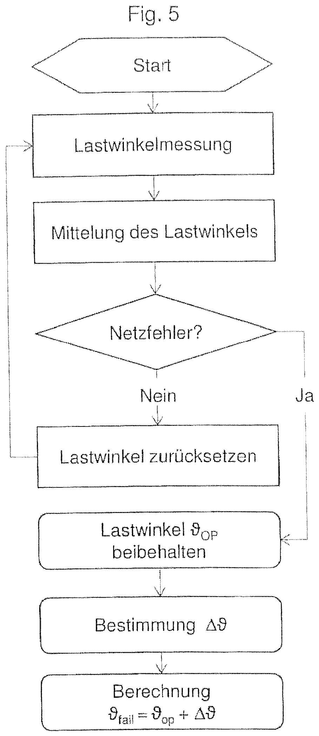

Fig. 5 zeigt ein Ablaufdiagramm des erfinderischen Verfahrens gemäß einem Ausführungsbeispiel. Die in einer Steuereinrichtung hinterlegbare Routine beginnt bei dem Schaltbild "Start" und kann beispielsweise alle 10 ms (Millisekunden) erneut durchlaufen werden. In einem ersten Schritt ("Lastwinkelmessung") erfolgt eine Lastwinkelmessung des Lastwinkels im netzstörungsfreien Betrieb des Synchrongenerators 2. Die Bestimmung des Lastwinkels kann dabei in an sich bekannter Weise, beispielsweise über eine Frequenz einer Generatorspannung $U_G$ und eines Generatorstroms $I_G$ des Synchrongenerators 2 erfolgen.

In einem nächsten Schritt, "Mittelung des Lastwinkels", erfolgt eine Mittelung des Lastwinkels über die letzten 500 ms (Millisekunden).

Tritt kein Netzfehler auf, wird durch die Routine ein neuer Mittelwert des Lastwinkels gebildet, in den das Ergebnis der letzten Lastwinkelmessung einfließt. Es wird also der Mittelwert des Lastwinkels durch diese Routine kontinuierlich überschrieben, sodass der Mittelwert des Lastwinkels stets der Mittelwert des Lastwinkels der letzten 500 ms (Millisekunden) darstellt.

Tritt ein Netzfehler auf, wird der zuletzt ermittelte Mittelwert des Lastwinkels des störungsfreien Betriebs als Ausgangswert $\vartheta_{OP}$ für die oben beschriebene Integration gespeichert. In anderen Worten wird der letzte netzgültige Wert eingefroren.

Durch die Routine wird erreicht, dass der zur Bestimmung des Lastwinkels $\vartheta_{fail}$ bei Vorliegen eines Netzfehlers herangezogene Wert des Lastwinkels $\vartheta_{op}$ des störungsfreien Betriebes dem Lastwinkel vor Auftreten des Netzfehlers entspricht.

Somit gehen in die Ermittlung des Lastwinkels $\vartheta_{op}$ keine durch einen Netzfehler verursachten Artefakte ein.

Nun wird wie weiter oben bereits erläutert, die Lastwinkeldifferenz $\Delta\vartheta$ bestimmt.

Die Lastwinkeldifferenz $\Delta\vartheta$ wird so bestimmt, dass ein Integral aus der Motorfrequenz (= Generatorfrequenz) aus einer Drehzahlmessung des Generators gebildet wird. Man erfasst dazu die Drehzahlentwicklung nach dem Netzfehler ausgehend von einer Startdrehzahl. Durch die Beschleunigung des Generators nimmt seine Drehzahl zu. Dies ist zusammen mit den sich ergebenden Werten der Lastwinkeldifferenz $\Delta\vartheta$ im Diagramm der Figur 4 dargestellt.

Schließlich wird der Lastwinkels bei Vorliegen eines Netzfehlers $\vartheta_{fail}$ berechnet:

$$\vartheta_{fail} = \vartheta_{op} + \Delta\vartheta$$

Damit erhält man die Information über den Lastwinkels bei Vorliegen eines Netzfehlers. Aus dem Lastwinkels bei Vorliegen eines Netzfehlers, $\vartheta_{fail}$ , kann nun z.B. eine Entscheidung darüber abgeleitet werden, ob der Synchrongenerator mit dem Energieversorgungsnetz verbunden bleibt.

Die Erkennung eines Netzfehlers kann beispielsweise darin bestehen, dass die Generatorfrequenz überwacht wird und eine Veränderung der Generatorfrequenz von größer als 0,1 Hz/10 ms als Auftreten eines Netzfehlers interpretiert wird.

Ist eine Änderung der Generatorfrequenz kleiner als 0,1 Hz/10 ms und die Drehzahl der mit dem Synchrongenerator 2 verbundenen Leistungsquelle 7 innerhalb einer vorgebbaren Nenndrehzahl +/- beispielsweise 10 U/min, so wird die Meldung eines Netzfehlers wieder zurückgesetzt. Dies kann beispielsweise nach Abklingen eines Netzfehlers der Fall sein.

Liste der verwendeten Bezugszeichen:

| | |
|---|---|
| 1 | Energieversorgungsnetz |
| 2 | Synchrongenerator |
| 3 | Rotor (Polrad) |
| 4 | Messeinrichtung zur Bestimmung einer Frequenz einer Generatorspannung und/oder eines Generatorstroms des Synchrongenerators |
| 5 | Drehzahlmesseinrichtung |
| 6 | Auswerteeinheit |
| 7 | Mechanische Leistungsquelle |
| 8 | Phase |
| 9 | Brennkraftmaschine |
| 10 | Windkraftanlage |
| 11 | Schaltvorrichtung |
| 12, 13 | Signalleitung |
| $\vartheta_{OP}$ | Lastwinkel im netzstörungsfreien Betrieb |
| $\vartheta_{fail}$ | Lastwinkel bei Netzstörung |
| $\Delta\vartheta$ | Lastwinkeldifferenz |
| $f_G$ | Generatorfrequenz |
| $f_{grid}$ | Netzfrequenz |
| $U_G$ | Generatorspannung |
| $I_G$ | Generatorstrom |
| $U_{Polrad}$ | Polradspannung |

**Patentansprüche**

1. Verfahren zur Erkennung eines bevorstehenden Polschlupfes eines mit einem Energieversorgungsnetz (1) elektrisch verbundenen Synchrongenerators (2), wobei ein für einen Netzfehler charakteristisches Signal erkannt wird und bei Steigerung eines Lastwinkels des Synchrongenerators (2) über einen vorgebbaren Wert ein drohender Polschlupf festgestellt wird, **gekennzeichnet durch** folgende Schritte:

   - Bestimmung eines ersten Lastwinkels ($\vartheta_{OP}$) im netzstörungsfreien Betrieb,
   - Ermittlung einer Generatorfrequenz ($f_G$) in Abhängigkeit von der Zeit bei Auftreten einer Netzstörung und
   - Vorausberechnung eines zweiten, aus der Netzstörung resultierenden, Lastwinkels ($\vartheta_{fail}$) durch Addieren des Wertes des ersten Lastwinkels ($\vartheta_{OP}$) mit einer während der Netzstörung auftretenden Lastwinkeldifferenz ($\Delta\vartheta$), welche Lastwinkeldifferenz ($\Delta\vartheta$) durch eine Abweichung einer Generatorfrequenz ($f_G$) relativ zu einer Netzfrequenz ($f_{grid}$) verursacht ist und aus dem Integral aus der Generatorfrequenz ($f_G$) aus einer Drehzahlmessung des Synchrongenerators (2) gebildet wird.

2. Verfahren nach Anspruch 1, wobei nach Detektion eines für einen Netzfehler charakteristischen Signals eine Winkelabweichung zwischen einer Polradspannung ($U_{Polrad}$) und einer Generatorspannung ($U_G$) bestimmt wird, welche Winkelabweichung durch eine Abweichung einer Generatorfrequenz ($f_G$) relativ zu einer Netzfrequenz ($f_{grid}$) verursacht ist.

3. Verfahren nach wenigstens einem der vorangegangenen Ansprüche, **dadurch gekennzeichnet, dass** die Bestimmung des ersten Lastwinkels ($\vartheta_{OP}$) im netzstörungsfreien Betrieb durch Messen einer Generatorspannung ($U_G$)

und eines Generatorstroms ($I_G$) erfolgt.

4. Verfahren nach wenigstens einem der vorangegangenen Ansprüche, **dadurch gekennzeichnet, dass** aus dem berechneten Wert eines aus der Netzstörung resultierenden zweiten Lastwinkels ($\vartheta_{fail}$) eine Entscheidung darüber abgeleitet wird, ob der Synchrongenerator (2) mit dem Energieversorgungsnetz (1) verbunden bleibt.

5. Verfahren nach wenigstens einem der vorangegangenen Ansprüche, **dadurch gekennzeichnet, dass** bei Überschreiten eines ersten vorgebbaren Wertes für den aus der Netzstörung resultierenden zweiten Lastwinkel ($\vartheta_{fail}$) wenigstens eine Maßnahme zur Reduzierung des Lastwinkels ($\vartheta_{fail}$) gesetzt wird.

6. Verfahren nach wenigstens einem der vorangegangenen Ansprüche, **dadurch gekennzeichnet, dass** bei Überschreiten eines zweiten vorgebbaren Wertes für den aus der Netzstörung resultierenden zweiten Lastwinkel ($\vartheta_{fail}$) der Synchrongenerator (2) von dem Energieversorgungsnetz (1) getrennt wird.

7. Vorrichtung zur Ermittlung eines Lastwinkels eines mit einem Energieversorgungsnetz (1) elektrisch verbundenen Synchrongenerators (2) mit einem Rotor (3), umfassend

   - wenigstens eine Messeinrichtung (4) zur Bestimmung einer Frequenz einer Generatorspannung ($U_G$) und / oder eines Generatorstroms ($I_G$) des Synchrongenerators (2),
   - wenigstens einer Drehzahlmesseinrichtung (5) zur Bestimmung einer Rotordrehzahl ($n_R$),
   - und wenigstens eine Auswerteeinheit (6), die dazu ausgebildet ist folgende Schritte auszuführen:

     • Bestimmung eines ersten Lastwinkels ($\vartheta_{OP}$) im netzstörungsfreien Betrieb,
     • Ermittlung einer Generatorfrequenz ($f_G$) in Abhängigkeit von der Zeit bei Auftreten einer Netzstörung und,
     • Vorausberechnung eines zweiten, aus der Netzstörung resultierenden Lastwinkels ($\vartheta_{fail}$) durch Addieren des Wertes des ersten Lastwinkels ($\vartheta_{OP}$) mit einer während der Netzstörung auftretenden Lastwinkeldifferenz ($\Delta\vartheta$), welche Lastwinkeldifferenz ($\Delta\vartheta$) durch eine Abweichung einer Generatorfrequenz ($f_G$) relativ zu einer Netzfrequenz ($f_{grid}$) verursacht ist und aus dem Integral aus der Generatorfrequenz ($f_G$) aus einer Drehzahlmessung des Synchrongenerators (2) gebildet wird.

8. Vorrichtung nach Anspruch 7, die Vorrichtung ferner umfassend eine mit dem Synchrongenerator (2) mechanisch gekoppelte mechanische Leistungsquelle (7).

9. Vorrichtung nach Anspruch 8, **dadurch gekennzeichnet, dass** die mechanische Leistungsquelle (7) eine Brennkraftmaschine (9), besonders bevorzugt ein stationärer Motor ist.

10. Vorrichtung nach Anspruch 8, **dadurch gekennzeichnet, dass** die mechanische Leistungsquelle (7) eine Windkraftanlage (10), eine Wasserkraftanlage oder eine Gasturbine ist.

**Claims**

1. Method for detecting an imminent pole slip of a synchronous generator (2) electrically connected to a power grid (1), wherein a signal characteristic of a grid fault is detected, and an impending pole slip is ascertained when a load angle of the synchronous generator (2) increases above a predefinable value, **characterized by** the following steps:

   - determining a first load angle ($\vartheta_{OP}$) during operation without a grid disturbance,
   - determining a generator frequency ($f_G$) as a function of the time when a grid disturbance occurs, and
   - precalculating a second load angle ($\vartheta_{fail}$) resulting from the grid disturbance by adding the value of the first load angle ($\vartheta_{OP}$) to a load angle difference ($\Delta\vartheta$) occurring during the grid disturbance, which load angle difference ($\Delta\vartheta$) is caused by a deviation of a generator frequency ($f_G$) relative to a grid frequency ($f_{grid}$) and is formed from the integral of the generator frequency ($f_G$) from a rotational speed measurement of the synchronous generator (2).

2. Method according to claim 1, wherein, after detecting a signal characteristic of a grid fault, an angle deviation between a synchronous generated voltage ($U_{Polrad}$) and a generator voltage ($U_G$) is determined, which angle deviation is caused by a deviation of a generator frequency ($f_G$) relative to a grid frequency ($f_{grid}$).

3. Method according to at least one of the preceding claims, **characterized in that** the first load angle ($\vartheta_{OP}$) is determined during operation without a grid disturbance by measuring a generator voltage ($U_G$) and a generator current ($I_G$).

4. Method according to at least one of the preceding claims, **characterized in that**, from the calculated value of a second load angle ($\vartheta_{fail}$) resulting from the grid disturbance, a decision is derived as to whether the synchronous generator (2) remains connected to the power grid (1).

5. Method according to at least one of the preceding claims, **characterized in that**, when a first predefinable value for the second load angle ($\vartheta_{fail}$) resulting from the grid disturbance is exceeded, at least one measure is taken to reduce the load angle ($\vartheta_{fail}$).

6. Method according to at least one of the preceding claims, **characterized in that**, when a second predefinable value for the second load angle ($\vartheta_{fail}$) resulting from the grid disturbance is exceeded, the synchronous generator (2) is disconnected from the power grid (1).

7. Device for determining a load angle of a synchronous generator (2) with a rotor (3) that is electrically connected to a power grid (1), comprising

- at least one measuring device (4) for determining a frequency of a generator voltage ($U_G$) and/or of a generator current ($I_G$) of the synchronous generator (2),
- at least one rotational speed measuring device (5) for determining a rotor speed ($n_R$),
- and at least one evaluation unit (6), which is formed to perform the following steps:

• determining a first load angle ($\vartheta_{OP}$) during operation without a grid disturbance,
• determining a generator frequency ($f_G$) as a function of the time when a grid disturbance occurs, and
• precalculating a second load angle ($\vartheta_{fail}$) resulting from the grid disturbance by adding the value of the first load angle ($\vartheta_{OP}$) to a load angle difference ($\Delta\vartheta$) occurring during the grid disturbance, which load angle difference ($\Delta\vartheta$) is caused by a deviation of a generator frequency ($f_G$) relative to a grid frequency ($f_{grid}$) and is formed from the integral of the generator frequency ($f_G$) from a rotational speed measurement of the synchronous generator (2).

8. Device according to claim 7, the device further comprising a mechanical power source (7) mechanically coupled to the synchronous generator (2).

9. Device according to claim 8, **characterized in that** the mechanical power source (7) is an internal combustion engine (9), particularly preferably a stationary engine.

10. Device according to claim 8, **characterized in that** the mechanical power source (7) is a wind turbine (10), a hydroelectric installation or a gas turbine.

**Revendications**

1. Procédé de reconnaissance d'un glissement de pôle imminent d'un générateur synchrone (2) relié électriquement à un réseau d'alimentation en énergie (1), dans lequel un signal caractéristique d'une panne de réseau est reconnu et lors de l'augmentation d'un angle de charge du générateur synchrone (2) au-dessus d'une valeur prédéfinissable, un glissement de pôle menaçant est constaté, **caractérisé par** les étapes suivantes :

- la détermination d'un premier angle de charge ($\vartheta_{OP}$) dans le fonctionnement sans panne de réseau,
- le calcul d'une fréquence de générateur ($f_G$) en fonction du temps lors de la survenue d'une panne de réseau et
- le calcul préalable d'un deuxième angle de charge ($\vartheta_{fail}$) résultant de la panne de réseau par ajout de la valeur du premier angle de charge ($\vartheta_{OP}$) avec une différence d'angle de charge ($\Delta\vartheta$) survenant pendant la panne de réseau, laquelle différence d'angle de charge ($\Delta\vartheta$) est causée par un écart d'une fréquence de générateur ($f_G$) par rapport à une fréquence de réseau ($f_{grid}$) et est formée à partir de l'intégrale de la fréquence de générateur ($f_G$) d'une mesure de vitesse de rotation du générateur synchrone (2).

2. Procédé selon la revendication 1, dans lequel après la détection d'un signal caractéristique d'une panne de réseau, un écart d'angle entre une tension de roue polaire ($U_{Polard}$) et une tension de générateur ($U_G$) est déterminé, lequel écart angulaire est causé par un écart d'une fréquence de générateur ($f_G$) par rapport à une fréquence de réseau ($f_{grid}$).

3. Procédé selon au moins l'une des revendications précédentes, **caractérisé en ce que** la détermination du premier angle de charge ($\vartheta_{OP}$) est effectuée dans le fonctionnement sans panne de réseau par mesure d'une tension de générateur ($U_G$) et d'un courant de générateur ($I_G$).

4. Procédé selon au moins l'une des revendications précédentes, **caractérisé en ce qu'**à partir de la valeur calculée d'un deuxième angle de charge ($\vartheta_{fail}$) résultant de la panne de réseau, une décision est déduite sur le fait si le générateur synchrone (2) reste relié au réseau d'alimentation en énergie (1).

5. Procédé selon au moins l'une des revendications précédentes, **caractérisé en ce que** lors du dépassement d'une première valeur prescriptible pour le deuxième angle de charge ($\vartheta_{fail}$) résultant de la panne de réseau, au moins une mesure de réduction de l'angle de charge ($\vartheta_{fail}$) est prise.

6. Procédé selon au moins l'une des revendications précédentes, **caractérisé en ce que** lors du dépassement d'une deuxième valeur prescriptible pour le deuxième angle de charge ($\vartheta_{fail}$) résultant de la panne de réseau, le générateur synchrone (2) est séparé du réseau d'alimentation en énergie (1).

7. Dispositif de calcul d'un angle de charge d'un générateur synchrone (2) relié électriquement à un réseau d'alimentation en énergie (1) avec un rotor (3) comprenant

   - au moins un dispositif de mesure (4) pour la détermination d'une fréquence d'une tension de générateur ($U_G$) et/ou d'un courant de générateur ($I_G$) du générateur synchrone (2),
   - au moins un dispositif de mesure de vitesse de rotation (5) pour la détermination d'une vitesse de rotation de rotor ($n_R$),
   - et au moins une unité d'évaluation (6) qui est réalisée afin de réaliser les étapes suivantes :

     • la détermination d'un premier angle de charge ($\vartheta_{OP}$) dans le fonctionnement sans panne de réseau,
     • le calcul d'une fréquence de générateur ($f_G$) en fonction du temps lors de la survenue d'une panne de réseau et,
     • le calcul préalable d'un deuxième angle de charge ($\vartheta_{fail}$) résultant de la panne de réseau par ajout de la valeur du premier angle de charge ($\vartheta_{OP}$) avec une différence d'angle de charge ($\Delta\vartheta$) survenant pendant la panne de réseau, laquelle différence d'angle de charge ($\Delta\vartheta$) est causée par un écart d'une fréquence de générateur ($f_G$) par rapport à une fréquence de réseau ($f_{grid}$) et est formée à partir de l'intégrale de la fréquence de générateur ($f_G$) d'une mesure de vitesse de rotation du générateur synchrone (2).

8. Dispositif selon la revendication 7, le dispositif comprenant de plus une source de puissance (7) mécanique couplée mécaniquement au générateur synchrone (2).

9. Dispositif selon la revendication 8, **caractérisé en ce que** la source de puissance (7) mécanique est un moteur à combustion interne (9), de manière particulièrement préférée un moteur stationnaire.

10. Dispositif selon la revendication 8, **caractérisé en ce que** la source de puissance (7) mécanique est une éolienne (10), une centrale hydroélectrique ou une turbine à gaz.

Fig. 1

Fig. 2

EP 3 284 167 B1

Fig. 3

12

Fig. 4

EP 3 284 167 B1

## Fig. 5

```
                    ┌─────────────┐
                    │    Start    │
                    └─────────────┘
                           │
                           ▼
            ┌──────────────────────────────┐
  ┌────────▶│     Lastwinkelmessung        │
  │         └──────────────────────────────┘
  │                        │
  │                        ▼
  │         ┌──────────────────────────────┐
  │         │   Mittelung des Lastwinkels   │
  │         └──────────────────────────────┘
  │                        │
  │                        ▼
  │              ◇ Netzfehler? ◇──────────────┐ Ja
  │                        │                   │
  │                      Nein                  │
  │                        │                   │
  │                        ▼                   │
  │         ┌──────────────────────────────┐  │
  └─────────│    Lastwinkel zurücksetzen    │  │
            └──────────────────────────────┘  │
                           │                   │
                           ▼                   │
            ┌──────────────────────────────┐  │
            │     Lastwinkel ϑOP            │◀─┘
            │       beibehalten             │
            └──────────────────────────────┘
                           │
                           ▼
            ┌──────────────────────────────┐
            │      Bestimmung  Δϑ           │
            └──────────────────────────────┘
                           │
                           ▼
            ┌──────────────────────────────┐
            │       Berechnung              │
            │   ϑfail = ϑop + Δϑ            │
            └──────────────────────────────┘
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010001248 A1
- AT 514007 A1
- AT 514024 A1
- US 2013168960 A1
- WO 2011088483 A1

**In der Beschreibung aufgeführte Nicht-Patentliteratur**

- **OHURA et al.** A predictive out-of-step protection system based on observation of the phase difference between substations. *IEEE Transactions on Power Delivery,* Oktober 1990, vol. 5 (4), 1695-1704